# EUROPEAN PATENT APPLICATION

(11) **EP 4 376 559 A1**
(43) Date of publication of application: **29.05.2024**
(21) Application number: 22209946.7
(22) Date of filing: 28.11.2022
(51) Int. Cl.: H05K 1/02, H05K 1/11, H05K 3/32, H05K 1/18

(54) **PRINTED CIRCUIT BOARD AND METHOD FOR PRODUCING THE SAME**

(71) Applicant: AT & S Austria Technologie & Systemtechnik Aktiengesellschaft, 8700 Leoben-Hinterberg (AT)
(72) Inventor: Krivec, Thomas, 8740 Zeltweg (AT); Schulz, Gernot, 8020 Graz (AT)
(74) Representative: Donatello, Daniele

(57) **Abstract**

Printed circuit board (10) made of a layer assembly (6) of overlapping layers (1, 2, 3, 4, 5), wherein the layer assembly (6) has a main portion (9) and at least one secondary portion (8), which secondary portion (8) is integrally formed with the main portion (9) and deformed relative to the main portion (9), preferably out of the plane in which the main portion (9) extends, wherein the layer assembly (6) comprises a first insulating layer (1), wherein the first insulating layer (1) is made of a material, particularly a composite material, that shrinks when being cured and/or cooled down, such that tensile stress is introduced into the first insulating layer (1),
the secondary portion (8) is forced into the deformed state by internal tensile stress within a first area (11) of the first insulating layer (1), wherein in a second area (12) of the layer assembly (6) the layer assembly (6) is locally weakened, wherein the first area (11) and the second area (12) are arranged one above the other and/or next to each other.

## Description

The invention relates to a printed circuit board according to the preamble of claim 1 and to a method for producing a printed circuit board.

In prior art printed circuit boards are known, which have elastic portions integrally formed with the board. The elastic characteristic of those portions may compensate distance changes due to thermal expansion.

DE4107657A1 discloses a printed circuit board having integrally formed tongue-like portions which are separated from the main portion by means of gaps. The tongue-like portions are completely surrounded by the main portion of the printed circuit board. In each tongue-like portion a hole is provided for a connection pin. Due to the spring characteristic of the tongue-like portions the forces arising due to thermal expansion and acting on the solder contacts are reduced.

DE3903615A1 discloses a printed circuit board having a tongue-like portion formed by a cut along its contour. The tongue-like portion is provided with an electrical contact for an electrical component.

DE19630794A1 discloses a temperature measurement device. The measurement element is arranged on a spring element which is integrated within the printed circuit board. By this way tolerances due to production may be compensated by the elastic characteristics of the spring element.

The disadvantages of such solutions consist by the fact that, if there is no external load exerted by electrical connections or other components (e.g. due to thermal stress) - the secondary (spring or tongue-like) portions always lie within the plane of the remaining (main) portion of the printed circuit board. Due to the fact, that in the equilibrium state (i.e. without external loads) there is no deflection of that secondary portions, the area of application of such boards is restricted. Rather, there is the need for printed circuit boards providing different contacting strategies and functionalities.

It is therefore an object of the invention to provide printed circuit boards having secondary portions which open new areas of application, particularly with respect to smart electrical contacting strategies or mechanical connection strategies. Furthermore, the production of such printed circuit boards should become easy and cost effective.

The object is achieved by a printed circuit board as mentioned at the beginning in that the secondary portion is forced into the deformed/bent state by internal tensile stress within a first area of the first insulating layer, wherein in a second area of the layer assembly the layer assembly is locally weakened, wherein the first area and the second area are arranged one above the other and/or next to each other.

The secondary portion(s) may be integrally connected with the main portion by means of at least one connection area. The first area (in which tensile stress causes bending of the secondary porting) and the second area (in which the layer assembly is locally weakened) preferably overlap with the connection area. According to the invention the secondary portion is deformed/bent relative to the main portion, out of the plane in which the main portion extends, more preferably with at least part of the secondary portion inclined with respect to the plane in which the main portion extends, due to internal forces in the layer assembly. Accordingly, the secondary portion may be in a deformed/bent state also without external forces. The secondary portions may thus have spring characteristics which are different from those known from prior art. For example, electrical contacts may be established without the need of soldering the contacts. The secondary portion may be brought in the spring-loaded state by providing a load which counteracts the internal force bringing and holding the secondary portion in the deformed/bent state. According to the inventive solution the areas of application are increased. The concept of influencing the balance between internal stresses by (mechanically) weakening the layer assembly in the second area, such that the internal tensile stress in the first area causes a deformation/bending, also allows a simple and cost-effective production method.

Material shrinkage can occur when being cured and/or cooled down, i.e. due to crosslinking at or subsequent to the lamination process. Shrinkage causes tensional stresses in the insulating (i.e. dielectric) layer that will be subsequently maintained after the lamination process. Locally weakening of the layer arrangement in the second area (e.g. by a cut) causes that stresses are released (e.g. within one layer). Weakening and/or removing material decouples the stresses in the second area. As a result, a "stress free" or "low stress" area is created. The resulting imbalance of stresses (e.g. of the top layer and the bottom layer) causes the deformation (or bending).

Several dielectric materials are known in the field of the printed circuit boards that in the form of a layer shrink when being cured and/or cooled down (i.e. through the lamination); in principle any polymeric material used in this field has this effect; the insulating layer may comprises at least one of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres, or other kinds of filler particles, for example made of glass (multilayer glass) in order to form a composite, could be used as well. A semi-cured resin in combination with a reinforcing agent, e.g. fibers impregnated with the above-mentioned resins is for example called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred.

"Weakening" is understood as "mechanical weakening" in the sense of influencing the mechanical properties of the layer arrangement in the region of the second area. Although the weakening process itself may be done - alternatively to mechanical processes (cutting, ablating, etc. and/or provision of a thinner portion on an area of a specific layer and/or of the layer assembly, especially comprising at least one of the materials listed above) - also by heat and/or chemicals, always the mechanical properties of the layer arrangement are influenced.

Due to its (spring) characteristic the secondary portion with the connection area may form a spring element. The spring characteristic may be used for contacting and/or connecting the secondary portion or the printed circuit board to other components, i.e. the spring force ensures reliable contact and connections.

In the context of the present application, the term "printed circuit board" (PCB) may particularly denote a plate-shaped component carrier which is formed by laminating conductive layers with several insulating layers, for instance by applying pressure and/or by the supply of thermal energy. As preferred materials for PCB technology, the conductive layers are made of copper, whereas the insulating layers may comprise resin and/or glass fibers, so-called prepreg or FR4 material. The various electrically conductive layers may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

During the printed circuit board production, the (first) insulating layer is brought upon another layer. During the curing or cooling-down process and due to the material shrinkage (i.e. volume reduction) internal tensile stress occurs.

The secondary portion(s) may have any shape and location; they may be e.g. the outer edges or corners of the layer assembly, but they may be also completely surrounded by the main portion.

In a preferred embodiment the secondary portion is separated from the main portion by means of a gap or cut along the contour of the secondary portion thereby leaving at least one connection area which integrally connects the main portion with the secondary portion, wherein preferably the gap or cut extends through all layers of the layer assembly. The gap or cut releases the secondary portion except for the connection area and ensures that the effect of the tensile stress in the first area - and thus the deforming/bending force - is as large as possible. The gap or cut along the contour of the secondary portion provide a cheap and easy manufacturing step to create said portion.

In a preferred embodiment the layer assembly is locally weakened by at least one recess, particularly a gap, an incision and/or a hole, formed in the second area, wherein preferably the recess is at least partially filled with material, preferably with an expanding material, particularly foam material. The weakness through recess, gap, incision and hole can be done through the removal of material from one or more layers of the layer assembly or by the direct provision of a thinner portion during the manufacturing of said layer assembly. These ways to locally weak the layer assembly allow the provision of the deformed portion through cheap and well known manufacturing steps in the field of printed circuit boards. The option of filling the recess with material allows to increase the deforming/bending force by a compressive force exerted by the (expanding) material.

In a preferred embodiment the layer assembly comprises a second insulating layer, wherein the second insulating layer is made of a material, particularly a composite material, that shrinks when being cured and/or cooled down, such that tensile stress is introduced into the second insulating layer, wherein the second area in which the layer assembly is locally weakened is located in the second insulating layer, wherein preferably the second insulating layer is completely cut through in the second area. In this embodiment tensile stress is also provided within the second insulating (or dielectric) layer. However, by locally weakening the second insulating layer the tensile stress in the second area (counteracting the tensile stress in the first area of the first insulating layer) is reduced or eliminated at all. Thus, the balance is changed in that the counter-force is reduced/eliminated. As consequence the secondary portion is brought/held in the deformed state, especially in the case of a symmetric building of stacked layers.

In a preferred embodiment the layer assembly comprises between the first insulating layer and the second insulating layer at least one intermediate layer, wherein preferably the intermediate layer(s) comprise at least one electrically conductive layer and/or a third insulating layer, wherein preferably the first insulating layer and/or the second insulating layer is/are in direct contact with an electrically conductive layer. This configuration of layer assembly is the usual one of a staked layer assembly suitable to made a printed circuit board.

In a preferred embodiment one of the first insulating layer and the second insulating layer is the top layer of the layer assembly and the other insulating layer is the bottom layer of the layer assembly, and/or wherein the first area is located at the surface of one flat side of the printed circuit board and the second area is located opposite to the first area on the surface of the other flat side of the printed circuit board. In this embodiment the weakness of the second area and/or the second layer is simplified being enough its provision on an exposed and/or flat surface.

In a preferred embodiment the first insulating layer and/or the second insulating layer are made of an epoxy material and/or a pre-impregnated fibrous material.

In a preferred embodiment the secondary portion is completely surrounded by the main portion and/or wherein the secondary portion has the shape of a tongue or flap. Depending of the layout of the printed circuit board, the shrinkage of the material of the first insulating layer and the local weakness of the second area and preferably of the second insulating layer allow the deformation of the secondary portion even if the secondary portion is an integral part with the main portion forming the layer assembly or even in the form of a specific (extending) portion such as a tongue or a flap.

In a preferred embodiment the secondary portion is bent out of the plane in which the main portion extends, and/or wherein the bending angle between the secondary portion and the main portion amounts to at least 8°, preferably to at least 12°, more preferred to at least 15°. These values have been experimentally discovered through tests and simulations using the common materials (and their specific dimensions) used in the known applications of printed circuit boards as insulating layers; in view of these tests, the applicant has surprisingly discovered that the resulting bending between the secondary portion and the main portion reaches significant bending angle values.

In an alternative embodiment it would be also possible to select the first and second area such that a bending of the secondary portion occurs within the plane of the main portion, or at least with a component parallel to that plane.

In a preferred embodiment on the secondary portion at least one electrical contact is formed, wherein preferably the electrical contact is in electrical connection with the main portion via an electrically conductive layer of the layer assembly.

In a preferred embodiment the secondary portion is designed as an electrical contacting element which abuts against a further component of the printed circuit board or of an electronic device, wherein preferably the secondary portion and the further component are arranged such that the secondary portion is in a spring-loaded state exerting a spring force against the further component, and/or wherein the secondary portion is designed as a locking element by which the layer assembly is lockable, preferably in a snap-type manner, with a further component of the printed circuit board or of an electronic device. These preferred embodiments allow the use of the deformed secondary portion as a contacting element and / or as a locking element without the need of additional pushing components, such as spring elements.

The invention also relates to an electronic device, such as a computer or a mobile communication device, wherein the electronic device comprises at least one printed circuit board according to the invention and/or one of its embodiments.

The object of the invention is also achieved by means of a method for producing a printed circuit board made of a layer assembly of overlapping layers, preferably a printed circuit board as above described, wherein the layer assembly has a main portion and at least one secondary portion, which secondary portion is integrally formed with the main portion and deformed relative to the main portion, preferably out of the plane in which the main portion extends, the method comprising the step of
a) producing a layer assembly of overlapping layers, wherein the layer assembly comprises a first insulating layer, wherein the first insulating layer is made of a material, particularly a composite material, that shrinks when being cured and/or cooled down, such that tensile stress is introduced into the first insulating layer during the step of producing the layer assembly,
b) changing and/or destroying a balance between internal tensile stress within a first area of the first insulating layer and internal stress within a second area of the layer assembly,
   wherein the first area and the second area are arranged one above the other and/or next to each other,
   wherein step b) comprises: (mechanically) weakening the layer assembly in the second area by removing and/or weakening material of the second area, such that the secondary portion is forced into the deformed state by internal tensile stress within the first area of the first insulating layer.

The invention relates to a very smart production method, since no direct deformation/bending of the secondary portion is necessary. Instead, the deformed state is achieved by changing the balance between the internal stress in the first area and the internal stress in the second area. The method step of weakening the layer assembly in the second area by removing and/or weakening material of the second area can be performed precisely, reliably and without great effort.

In a preferred embodiment the method comprises the step of
c) separating the secondary portion from the main portion by means of a gap or cut along the contour of the secondary portion thereby leaving at least one connection area which integrally connects the main portion with the secondary portion, wherein preferably the gap or cut extends through all layers of the layer assembly, wherein preferably step c) is performed before step b). This preferred step and the related preferably alternative contribute to a easy and cheap production step to separate the first and the second portion.

In a preferred embodiment weakening the layer assembly in the second area is done by means of cutting and/or ablating material of the second area, preferably with a laser beam, and/or by means of a thinner portion on an area of a specific layer (i.e. the second insulating layer) and/or of the layer assembly and/or by means of heat and/or chemical treatment of the material of the second area.

In a preferred embodiment the layer assembly comprises a second insulating layer, wherein the second insulating layer is made of a material, particularly a composite material, that shrinks when being cured and/or cooled down, such that tensile stress is introduced into the second insulating layer during the step of producing the layer assembly, wherein the material of the second area, which is removed and/or weakened in step b), is a material of the second insulating layer.

In a preferred embodiment by removing and/or weakening material of the second area in step b) at least one recess, particularly a gap, an incision and/or a hole, is formed in the second area, wherein preferably the recess is at least partially filled with material, preferably with an expanding material, particularly foam material. In this embodiment the deformed state of the secondary portion, more preferably the spring effect imparted to it, is enhanced by the expanding material in the recess.

In a preferred embodiment in a step d) on the secondary portion at least one electrical contact is formed, wherein preferably the electrical contact is in electrical connection with the main portion via an electrically conductive layer of the layer assembly, and wherein preferably step d) is performed prior to step b). This preferred step allows a cheap and easy way to provide an electrical contact.

In a preferred embodiment in a step e) the layer assembly is mounted within an electronic device and/or assembled together with other components, wherein preferably step b) is performed subsequent to step e).

For a better understanding of the invention the latter is explained in more detail with reference to the following Figures. In a simplified, schematic representation:
Fig. 1 shows a printed circuit board according to the invention,
Fig. 2 shows the step of forming an electrical contact on the surface of the printed circuit board according to an embodiment of the invention,
Fig. 3 shows in a top view and a cross-sectional view electrical contacts on the surface of the printed circuit board according to an embodiment of the invention,
Fig 4 shows the step of separating - by means of a cut - a secondary portion from the main portion of the printed circuit board according to an embodiment of the invention,
Fig. 5 shows the step of weakening - by means of a laser beam - the layer assembly in a second area according to an embodiment of the invention,
Fig. 6 shows the upwards bending of the secondary portion due to the tensile stress within the first area of the first insulating layer according to an embodiment of the invention,
Fig. 7 shows an embodiment of the invention with secondary portions being formed at the corners of the printed circuit board,
Fig. 8 shows an embodiment of the invention with secondary portions being formed in a central area of the printed circuit board,
Fig. 9 shows a detail of an electronic device with an electrical component abutting with its contacts against secondary portions of a printed circuit board according to an embodiment of the invention,
Fig. 10 shows the step of connecting a printed circuit board according to an embodiment of the invention with a further component, wherein the secondary portion is part of a snap mechanism.

It is noted that the invention is not limited to the embodiments disclosed hereinbefore. Combinations of the different variants are possible. In reality, the printed circuit board may have more or less parts than shown in the Figures. The illustrations in the drawings are schematic. In different drawings, similar or identical elements are provided with the same reference signs. Finally, the description may comprise subject matter of further independent inventions.

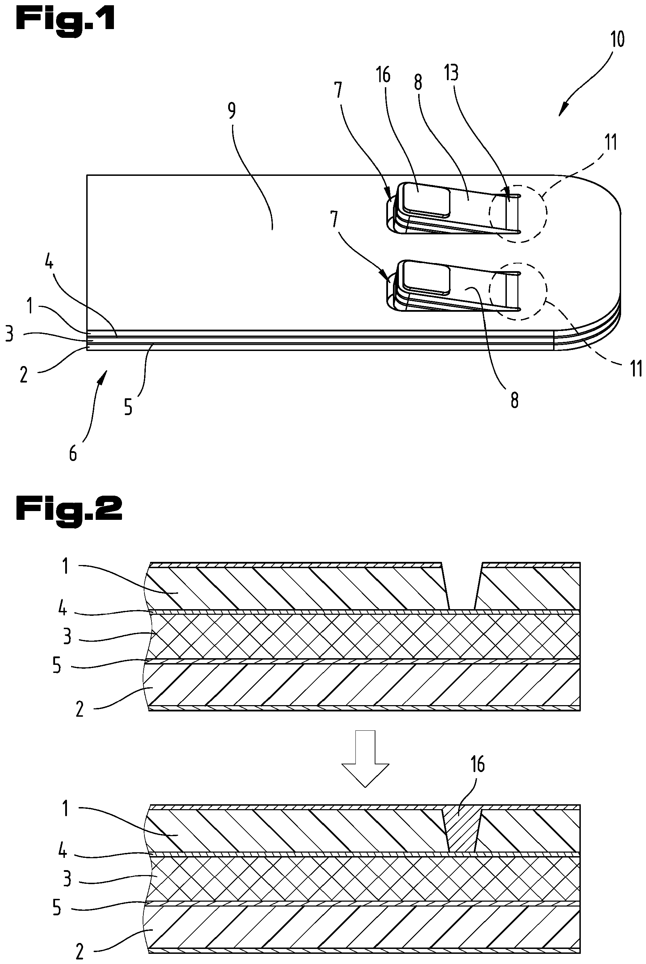

Fig. 1 shows a printed circuit board 10 according to the invention. Printed circuit board 10 is made of a layer assembly 6 of overlapping layers 1, 2, 3, 4, 5, wherein the layer assembly 6 has a main portion 9 and at least one (in Fig. 1: two) secondary portion 8. The secondary portions 8 are integrally formed with the main portion 9 and bent relative to the main portion 9.

In the embodiment of Fig. 1 the secondary portions 8 are preferably bent out of the plane in which the main portion 9 extends.

The layer assembly 6 comprises a first insulating layer 1 (preferably as top layer), wherein the first insulating layer 1 is made of a material, particularly a composite material, that shrinks when being cured and/or cooled down, such that tensile stress is introduced into the first insulating layer 1. This is particularly the case in materials in which crosslinking processes occur (resin, synthetic, polymer, plastic materials). Usually resin, particularly epoxy resin, materials are used for the first insulating layer. The resin may be provided within a so called prepreg (pre-impregnated fibre), from which the first insulating layer is made.

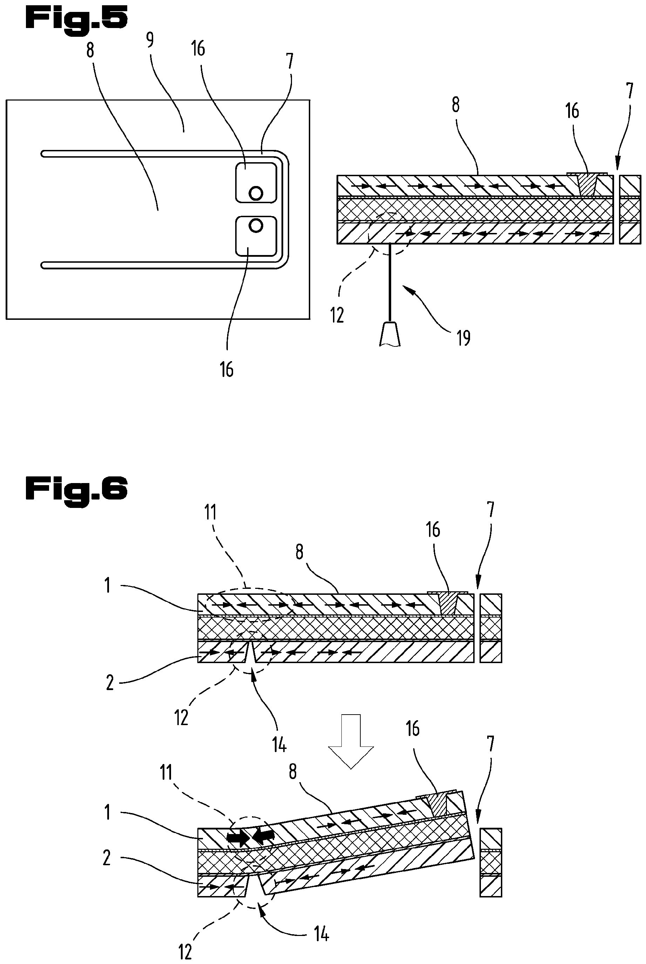

The secondary portion 8 is forced into the bent state by internal tensile stress within a first area 11 of the first insulating layer 1, while in a second area 12 of the layer assembly 6 the layer assembly 6 is locally weakened (see Figs 5. and 6). The first area 11 and the second area12 are arranged one above the other and/or next to each other. The first area 11 and the second area 12 preferably overlap with the connection area integrally connecting the secondary portion 8 with the main portion 9.

The layer assembly 6 may be locally weakened by at least one recess 14, particularly a gap, an incision and/or a hole, formed in the second area 12. In an embodiment the recess 14 may be at least partially filled with material, preferably with an expanding material, particularly foam material. The expanding material may additionally increase the deforming/bending force acting on the secondary portion.

Material (resin, e.g. epoxy resin) shrinkage may occur due to crosslinking at or subsequent to the lamination process. Shrinkage causes tensional stresses in the insulating (i.e. dielectric) layer. Locally weakening of the layer arrangement 6 in the second area 12 (e.g. by a cut) causes that stresses are released (e.g. within one layer). Weakening and/or removing material decouples the stresses in the second area 12. As a result, a "stress free" or "low stress" area is created. The resulting imbalance of stresses (e.g. of the top layer and the bottom layer) causes the deformation (or bending).

The layer assembly 6 of the present embodiment preferably further comprises a second insulating layer 2 (as bottom layer) and more preferably also an intermediate layer: a core layer (or core substrate) 3 and two electrically conductive layers 4, 5, preferably made of copper. The first insulating layer 1 and/or the second insulating layer 2 may be in direct contact with an electrically conductive layer 4, 5.

The second insulating layer 2 may be also made of a material, particularly a composite material, that shrinks when being cured and/or cooled down, such that tensile stress is introduced into the second insulating layer 2. The second insulating layer 2 may be formed from the same material as the first insulating material 1 (resin, epoxy resin, prepreg, etc.). The second area 12, in which the layer assembly 6 is locally weakened, is preferably located in the second insulating layer 2. Preferably, the second insulating layer 2 is completely cut through in the second area 2.

In the preferred shown embodiment, the layers 2, 3, 4 and 5 are bent under the action of the shrinkage of the first insulating layer 1 once the second insulating layer 2 has been locally weakened.

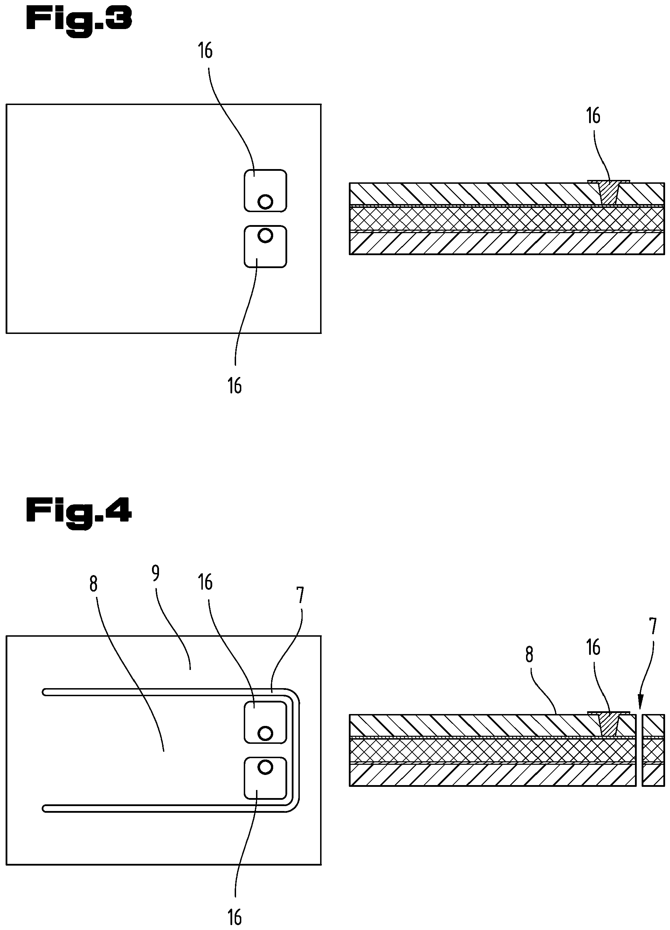

The secondary portion 8 may be separated from the main portion 9 by means of a gap or cut 7 along the contour of the secondary portion 8 thereby leaving at least one connection area 13 (see Figs. 1 and 4) which integrally connects the main portion 9 with the secondary portion 8.

The gap or cut 7 preferably extends through all layers 1, 2, 3, 4, 5 of the layer assembly 6.

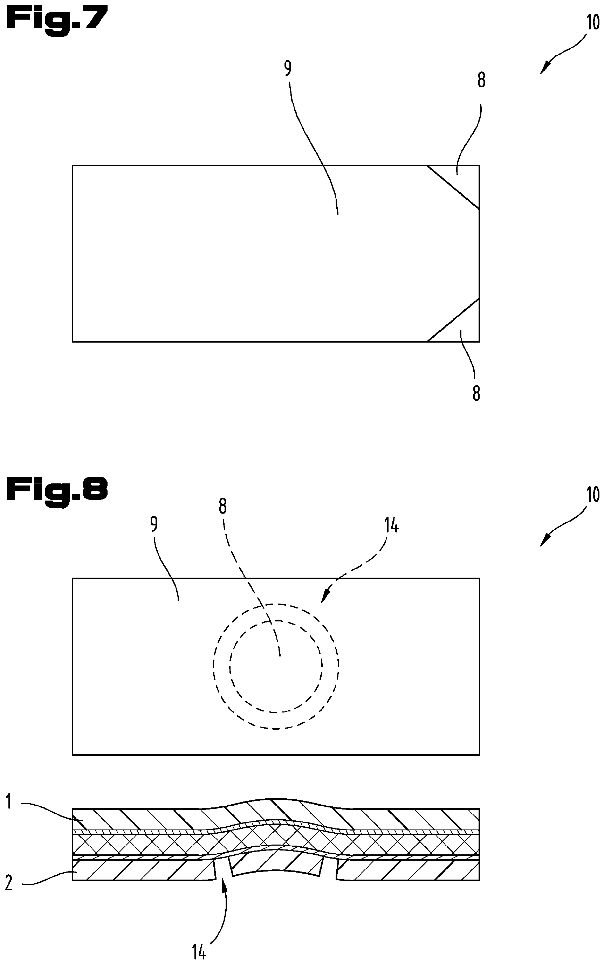

In other embodiments shown in Figs. 7 and 8 a gap or cut is not necessarily required.

In Fig. 7 the secondary portions 8 are formed by corners of the layer assembly. Alternatively, also an edge of the layer assembly may be used as secondary portion.

In Fig. 8 the secondary portion 8 is surrounded by the main portion 9 of the printed circuit board. The material of the second insulating layer 2 is preferably weakened or removed along a closed contour (here: along a ring), causing the secondary portion to be deformed / bent-up due to tensional forces within the first insulating layer.

However, it should be mentioned that in the embodiment of Fig. 8 the effect of deformation/bending can be smaller compared to that of the Figs. 1 to 7 (i.e. without providing a gap or cut 7 or using corners or edges as secondary portions).

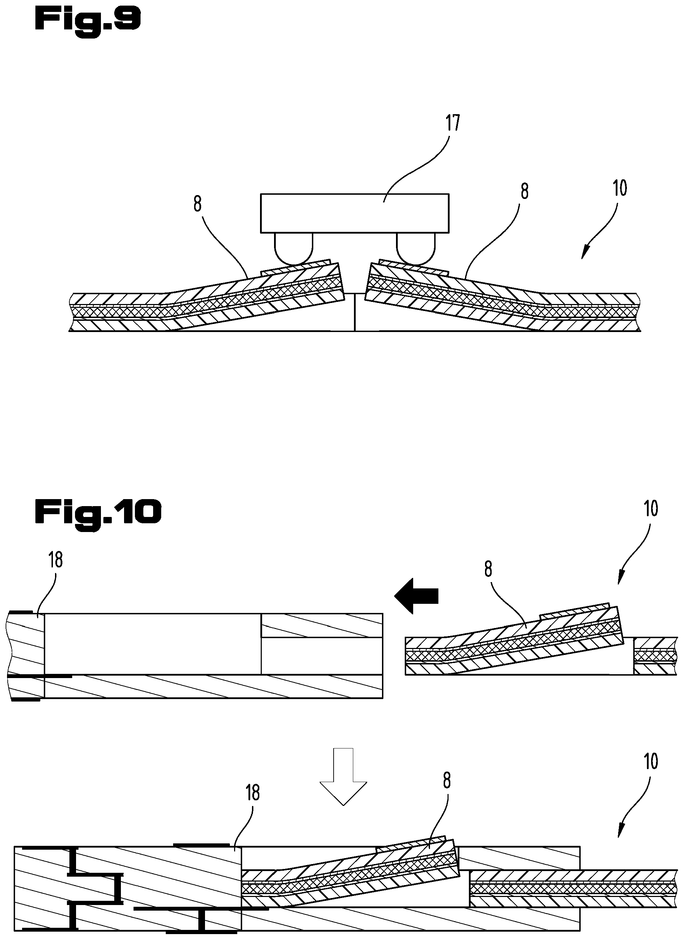

Due to its preferred spring characteristic the secondary portion(s) 8 with the connection area form(s) a spring element. The spring characteristic may be used for contacting and/or connecting the secondary portion 8 or the printed circuit board 10 to other components 17 or component carriers 18 (see Figs. 9, 10), i.e. the spring force ensures reliable contact and connections.

Preferably, if one of the first insulating layer 1 and the second insulating layer 2 is the top layer of the layer assembly 6 and the other insulating layer 1, 2 is the bottom layer of the layer assembly 6. The first area 11 is preferably located at the surface of one flat side of the printed circuit board 10 and the second area 12 is preferably located opposite to the first area 11 on the surface of the other flat side of the printed circuit board 10.

In the preferred embodiments of Figs. 1 to 6 the secondary portion 8 is completely surrounded by the main portion 9 and may have the shape of an elastically bendable tongue or flap. The secondary portion 8 is bent out of the plane in which the main portion 9 extends. It is preferred if the bending angle between the secondary portion 8 and the main portion 9 amounts to at least 8°, preferably to at least 12°, more preferred to at least 15°.

In other embodiments it would be also possible to select the first area (tensile stress) and second area (weakened) such that a bending of the secondary portion occurs within the plane of the main portion or with a bending direction which has a component parallel to that plane. For example, the first area and the second area may be arranged next to each other within the same insulating layer (both areas overlapping with the connection area 13). Weakening and/or removal of material within the second area then causes a bending of the secondary portion in a direction away from the second are to the first area.

As can be seen particularly from Fig. 2 on the secondary portion 8 at least one electrical contact 16 is preferably formed. The electrical contact 16 is in electrical connection with the main portion 9 via an electrically conductive layer 4 of the layer assembly 6. Etching and structure pattern processes to obtain such electrical contacts and conductive tracks - per se - are commonly known in art.

Fig. 9 shows that the secondary portion 8 may designed as an electrical contacting element which abuts against a further component 17 of the printed circuit board 10 or of an electronic device, wherein preferably the secondary portion 8 and the further component 17 are arranged such that the secondary portion 8 is in a spring-loaded state exerting a spring force against the further component 17.

Fig. 10 shows that the secondary portion 8 is designed as a locking element by which the layer assembly 6 is lockable, preferably in a snap-type manner, preferably with a further component carrier 18 of the printed circuit board 10 or of an electronic device.

The method for producing a printed circuit board 10 according to the invention is shown the Figs. 2 to 6. The method comprises the steps of:
a) producing a layer assembly 6 of overlapping layers 1, 2, 3, 4, 5, wherein the layer assembly 6 comprises a first insulating layer 1, wherein the first insulating layer 1 is made of a material, particularly a composite material, that shrinks when being cured and/or cooled down, such that tensile stress is introduced into the first insulating layer 1 during the step of producing the layer assembly (Fig. 2).
b) changing and/or destroying a balance between internal tensile stress within a first area 11 of the first insulating layer 1 and internal stress within a second area 12 of the layer assembly 6, wherein the first area 11 and the second area 12 are arranged one above the other and/or next to each other, wherein step b) comprises: (mechanically) weakening the layer assembly 6 in the second area 12 by removing and/or weakening material of the second area 12, such that the secondary portion 8 is forced into the bent state by internal tensile stress within the first area 11 of the first insulating layer 1 (Figs. 5 and 6).

Weakening the layer assembly 6 in the second area 12 may be done by means of cutting and/or ablating material of the second area 12, preferably with a laser beam, and/or by means of a thinner portion on an area of the second insulating layer 2, and/or by means of heat and/or chemical treatment of the material of the second area 12.

By the process of removing and/or weakening material of the second area 12 in step b) at least one recess 14, particularly a gap, an incision and/or a hole, may be formed in the second area 12. The recess 14 may be at least partially filled with material, preferably with an expanding material, particularly foam material.

The method may also comprise the step of:
c) separating the secondary portion 8 from the main portion 9 by means of a gap or cut 7 along the contour of the secondary portion 8 thereby leaving at least one connection area (13) which integrally connects the main portion 9 with the secondary portion 8, wherein preferably the gap or cut 7 extends through all layers 1, 2, 3, 4, 5 of the layer assembly 6 (Fig. 4).

Preferably, step c) is performed before step b). However, it would be also possible to perform step c) subsequent to or overlapping in time with step b).

The method may also comprise the step of:
d) forming on the secondary portion 8 at least one electrical contact 16. Preferably, the electrical contact 16 is in electrical connection with the main portion 9 via an electrically conductive layer 4, 5 of the layer assembly 6 Preferably, step d) is performed prior to step b).

The method may also comprise the step of:
e) mounting the layer assembly 6 within an electronic device and/or assembling together the layer assembly 6 with other components 17, 18.

In an embodiment step b) may be performed subsequent to step e).

The invention is not restricted to the embodiments shown. For example, alternative embodiments are possible, in which the secondary portion(s) is/are bent within the plane of the main portion of the printed circuit board or in which the bending direction has at least a component which lies within the plane of the main portion. Off course the printed circuit board may comprise a plurality of electrically conductive paths, tracks or pads and/or other features etched from one or more sheet layers of metal, particularly copper, laminated onto and/or between sheet layers of a non-conductive substrate (insulating layers). Also (a plurality of) electrical components may be mounted to the layer assembly of the printed circuit board.

### Reference signs

1 first insulating layer
2 second insulating layer
3 core layer
4 conductive layer
5 conductive layer
6 layer assembly
7 gap, cut
8 secondary portion
9 main portion
10 printed circuit board
11 first area
12 second area
13 connection area
14 recess
16 electrical contact
17 further component
18 further component carrier or further printed circuit board
19 laser beam

## Claims

1. Printed circuit board (10) made of a layer assembly (6) of overlapping layers (1, 2, 3, 4, 5), wherein the layer assembly (6) has a main portion (9) and at least one secondary portion (8), which secondary portion (8) is integrally formed with the main portion (9) and deformed relative to the main portion (9), preferably out of the plane in which the main portion (9) extends, wherein the layer assembly (6) comprises a first insulating layer (1), wherein the first insulating layer (1) is made of a material, particularly a composite material, that shrinks when being cured and/or cooled down, such that tensile stress is introduced into the first insulating layer (1),
**characterized in that** the secondary portion (8) is forced into the deformed state by internal tensile stress within a first area (11) of the first insulating layer (1), wherein in a second area (12) of the layer assembly (6) the layer assembly (6) is locally weakened, wherein the first area (11) and the second area (12) are arranged one above the other and/or next to each other.

2. Printed circuit board according to claim 1, wherein the secondary portion (8) is separated from the main portion (9) by means of a gap or cut (7) along the contour of the secondary portion (8) thereby leaving at least one connection area (13) which integrally connects the main portion (9) with the secondary portion (8), wherein preferably the gap or cut (7) extends through all layers (1, 2, 3, 4, 5) of the layer assembly (6).

3. Printed circuit board according to claim 1 or 2, wherein the layer assembly (6) is locally weakened by at least one recess (14), particularly a gap, an incision and/or a hole, formed in the second area (12), wherein preferably the recess (14) is at least partially filled with material, preferably with an expanding material, particularly foam material.

4. Printed circuit board according to one of the preceding claims, wherein the layer assembly (6) comprises a second insulating layer (2), wherein the second insulating layer (2) is made of a material, particularly a composite material, that shrinks when being cured and/or cooled down, such that tensile stress is introduced into the second insulating layer (2), wherein the second area (12) in which the layer assembly (6) is locally weakened is located in the second insulating layer (2), wherein preferably the second insulating layer (2) is completely cut through in the second area (2).

5. Printed circuit board according to one of the preceding claims, wherein the layer assembly (6) comprises between the first insulating layer (1) and the second insulating layer (2) at least one intermediate layer (3, 4, 5), wherein preferably the intermediate layer(s) (3, 4, 5) comprise at least one electrically conductive layer (4, 5) and/or a third insulating layer (3),
wherein preferably the first insulating layer (1) and/or the second insulating layer (2) is/are in direct contact with an electrically conductive layer (4, 5).

6. Printed circuit board according to one of the preceding claims, wherein one of the first insulating layer (1) and the second insulating layer (2) is the top layer of the layer assembly (6) and the other insulating layer (1, 2) is the bottom layer of the layer assembly (6),
and/or wherein the first area (11) is located at the surface of one flat side of the printed circuit board (10) and the second area (12) is located opposite to the first area (11) on the surface of the other flat side of the printed circuit board (10).

7. Printed circuit board according to one of the preceding claims, wherein the first insulating layer (1) and/or the second insulating layer (2) are made of an epoxy material and/or a pre-impregnated fibre material,
and/or wherein the secondary portion (8) is completely surrounded by the main portion (9),
and/or wherein the secondary portion (8) has the shape of a tongue or flap.

8. Printed circuit board according to one of the preceding claims, wherein the secondary portion (8) is bent out of the plane in which the main portion (9) extends, and/or wherein the bending angle between the secondary portion (8) and the main portion (9) amounts to at least 8°, preferably to at least 12°, more preferred to at least 15°.

9. Printed circuit board according to one of the preceding claims, wherein on the secondary portion (8) at least one electrical contact (16) is formed, wherein preferably the electrical contact (16) is in electrical connection with the main portion (9) via an electrically conductive layer (4, 5) of the layer assembly (6).

10. Printed circuit board according to one of the preceding claims, wherein the secondary portion (8) is designed as an electrical contacting element which abuts against a further component (17) of the printed circuit board (10) or of an electronic device, wherein preferably the secondary portion (8) and the further component (17) are arranged such that the secondary portion (8) is in a spring-loaded state exerting a spring force against the further component (17),
and/or wherein the secondary portion (8) is designed as a locking element by which the layer assembly (6) is lockable, preferably in a snap-type manner, with a further component carrier or further component (18) of the printed circuit board (10) or of an electronic device.

11. Method for producing a printed circuit board (10) made of a layer assembly (6) of overlapping layers (1, 2, 3, 4, 5), preferably a printed circuit board according to one of the preceding claims, wherein the layer assembly (6) has a main portion (9) and at least one secondary portion (8), which secondary portion (8) is integrally formed with the main portion (9) and deformed relative to the main portion (9), preferably out of the plane in which the main portion (9) extends, the method comprising the step of
a) producing a layer assembly (6) of overlapping layers (1, 2, 3, 4, 5), wherein the layer assembly (6) comprises a first insulating layer (1), wherein the first insulating layer (1) is made of a material, particularly a composite material, that shrinks when being cured and/or cooled down, such that tensile stress is introduced into the first insulating layer (1) during the step of producing the layer assembly,
**characterized by** the step of
b) changing and/or destroying a balance between internal tensile stress within a first area (11) of the first insulating layer (1) and internal stress within a second area (12) of the layer assembly (6), wherein the first area (11) and the second area (12) are arranged one above the other and/or next to each other,
wherein step b) comprises: weakening the layer assembly (6) in the second area (12) by removing and/or weakening material of the second area (12), such that the secondary portion (8) is forced into the deformed state by internal tensile stress within the first area (11) of the first insulating layer (1).

12. Method according to claim 11, wherein the method comprises the step of
c) separating the secondary portion (8) from the main portion (9) by means of a gap or cut (7) along the contour of the secondary portion (8) thereby leaving at least one connection area (13) which integrally connects the main portion (9) with the secondary portion (8), wherein preferably the gap or cut (7) extends through all layers (1, 2, 3, 4, 5) of the layer assembly (6),
wherein preferably step c) is performed before step b).

13. Method according to claim 11 or 12, wherein weakening the layer assembly (6) in the second area (12) is done by means of cutting and/or ablating material of the second area (12), preferably with a laser beam, and/or by means of a thinner portion on an area of a specific layer and/or of the layer assembly, and/or by means of heat and/or chemical treatment of the material of the second area (12).

14. Method according to one of the claims 11 to 13, wherein the layer assembly (6) comprises a second insulating layer (2), wherein the second insulating layer (2) is made of a material, particularly a composite material, that shrinks when being cured and/or cooled down,
such that tensile stress is introduced into the second insulating layer (2) during the step of producing the layer assembly (6), wherein the material of the second area (12), which is removed and/or weakened in step b), is a material of the second insulating layer (2).

15. Method according to one of the claims 11 to 14, wherein by removing and/or weakening material of the second area (12) in step b) at least one recess (14), particularly a gap, an incision and/or a hole, is formed in the second area (12), wherein preferably the recess (14) is at least partially filled with material, preferably with an expanding material, particularly foam material, and/or
wherein in a step d) on the secondary portion (8) at least one electrical contact (16) is formed, wherein preferably the electrical contact (16) is in electrical connection with the main portion (9) via an electrically conductive layer (4, 5) of the layer assembly (6), and wherein preferably step d) is performed prior to step b), and/or wherein in a step e) the layer assembly (6) is mounted within an electronic device and/or assembled together with other components or component carriers (17, 18), wherein preferably step b) is performed subsequent to step e).
